# EUROPEAN PATENT SPECIFICATION

(11) **EP 0 355 742 B1**
(45) Date of publication and mention of the grant of the patent: **14.12.1994**
(21) Application number: 89115277.9
(22) Date of filing: 18.08.1989
(51) Int. Cl.: H03J 9/06

(54) **A commander apparatus**
Steuergerät
Appareil de commande

(30) Priority: 23.08.1988 JP 208583/88
(43) Date of publication of application: 28.02.1990
(73) Proprietor: SONY CORPORATION, Tokyo 141 (JP)
(72) Inventor: Korita, Tohru, Shinagawa-ku Tokyo (JP)
(74) Representative: TER MEER STEINMEISTER & PARTNER GbR

(56) References cited:
- EP-A- 0 129 286
- US-A- 4 623 887
- PATENT ABSTRACTS OF JAPAN, vol. 010293, 4th October 1986, page 105 E 443;& JP-A-61 111 089 (SONY CORP.) 29-05-1986

## Description

### BACKGROUND OF THE INVENTION

### Field of the Invention

The present invention relates generally to a remote control unit and, more specifically, to the key arrangement of a remote commander that is used in controlling the operation of electronic apparatus.

### Description of the Background

In recent years, it has become common that electronic apparatus, such as television receivers, VTR's, video disc players, and the like are controlled and operated using remote commanders. The arrangement of the keys on such remote commanders is predetermined by the manufacturer so as to provide the key arrangement for that particular unit that can be most easily used by the ordinary person. Nevertheless, because of the diversification of users and manufacturers, the key arrangements which are thought to be most easily used are not uniform. For instance, in the case of a remote commander used to control the operation of a VTR, the user who executes a number of editing operations frequently uses the operation keys relating to the edition process, such as still, slow pause, etc., so it is preferable that such operation keys are arranged at easily operable positions on the remote commander. On the other hand, for the user who rarely performs tape editing it is sufficient that such operation keys are arranged at any positions on the remote commander. This latter person requires that the operation keys for recording, reproducing, and the like not necessarily associated with editing be arranged at easily operable positions on the remote commander.

Nevertheless, in conventional remote commanders known heretofore, the key arrangement cannot be easily changed in accordance with the desires and operating habits of the user.

Furthermore, a remote commander is provided in correspondence with each unit of electronic apparatus, therefore, when an audio-visual system is assembled by combining a number of electronic units, a corresponding number of remote commanders are needed.

In Japanese Laid-open Patent Application 61/111089, there has been proposed a construction in which a command signal corresponding to each apparatus can be transmitted by changing a transmission card ROM in the remote commander. By using such a remote commander, a plurality of different electronic units can be operated by use of the single remote commander by inserting the card relating to that particular unit.

Even in such a remote commander, in which a command signal corresponding to the apparatus can be transmitted by changing the transmission card ROM, the key arrangement of the transmission card ROM cannot be freely set.

There also has been proposed a remote commander with what is called a learning function, in which the command signals that are output from other remote commanders are learned, so that various kinds of electronic units can be controlled by a single remote commander. By using such a commander with the learning function, a number of electronic units can be operated by one remote commander and there is no need to use a number of remote commanders.

Nevertheless, in such a commander having the learning function, in general, the names of the commands corresponding to the keys have previously been displayed or printed on the body of the commander and the command signals are learned by the user on the basis of the printed indicia on the commander. Therefore, the key arrangement actually cannot be freely set. On the other hand, in such a commander with the learning function, the command signals of that remote commander itself cannot be changed. Furthermore, in such commander, because a plurality of electronic units are controlled by one remote commander, up to one hundred different keys may have to be arranged on the remote commander main body. Thus, the operating efficiency of such a conventional commander with the learning function is not good.

### OBJECTS AND SUMMARY OF THE INVENTION

Accordingly, it is an object of the present invention to provide a remote control unit that can eliminate the above-noted defects inherent in the prior art. It is another object of the present invention to provide a commander apparatus in which the key arrangement can be freely set in accordance with the wishes of each user.

A further object of the present invention is to provide a commander apparatus in which the number of keys arranged on a remote commander main body are minimized and the operating efficiency is improved.

In accordance with one aspect of the present invention, there is provided a commander apparatus in which the recording media, into which control data corresponding to key switches is stored, are detachably enclosed in a remote commander main body, that comprises a receiving unit for receiving command signals that are supplied externally, a control unit for storing the control data that is obtained by demodulating the externally supplied command signals in correspondence to the key switches of the recording media, and a connector for coupling the recording media with the remote commander main body. The recording media may be one or more ROM cards or RAM cards that are detachably enclosed in a portion of the remote commander main body, so that the command data is stored in the ROM card or RAM card. The commander data of the other ROM card or RAM card can be transferred to the RAM card, and the command signals of other remote commanders can be demodulated and the resultant demodulated data stored in the RAM card.

By transferring the command data of the other ROM card or RAM card into the RAM card or by storing the command data of the other remote commander in the RAM card, a remote commander having an original key arrangement according to the requirements of the user can be realized.

The above and other objects, features, and advantages of the present invention will become readily apparent from the following detailed description thereof which is to be read in connection with the accompanying drawings in which like reference numerals represent the same or similar elements.

### BRIEF DESCRIPTION OF THE DRAWINGS

Fig. 1 is an exploded perspective view of a remote commander according to an embodiment of the present invention;
Fig. 2 is a front elevational view of the remote commander of Fig. 4;
Fig. 3 is a plan view of a ROM card according to an embodiment of the present invention;
Figs. 4A and 4B are plan views of RAM cards according to an embodiment of the present invention;
Fig. 5 is a schematic in block diagram form of the main circuitry of a remote commander according to an embodiment of the present invention;
Fig. 6 is a schematic in block diagram form of a ROM card according to an embodiment of the present invention;
Fig. 7 is a schematic in block diagram form of a RAM card according to an embodiment of the present invention; and
Figs. 8 and 9 are schematics in block diagram form showing the circuits of Figs. 6 and 7, respectively, installed in the circuit of Fig. 5.

### DETAILED DESCRIPTION OF PREFERRED EMBODIMENTS

In order to further understanding of the present invention it is described hereinbelow in the following order: (a) Overall construction of operable embodiment; (b) Circuit construction of a remote commander main body; (c) Circuit constructions of ROM card and RAM card; and (d) Method of using operable embodiment.

### (a) Overall construction of operable embodiment:

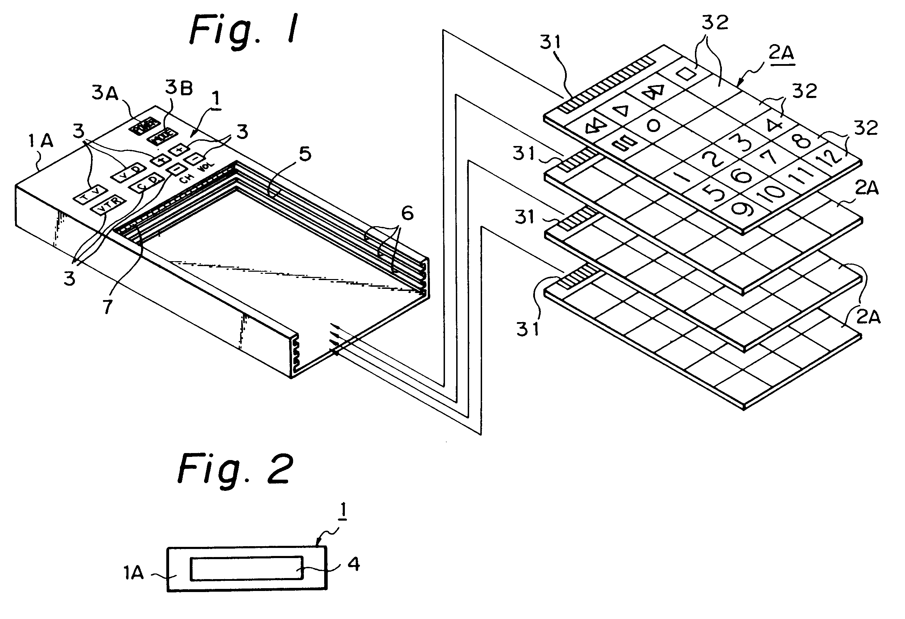

In Fig. 1, one or more ROM cards, shown typically at 2A, are adapted to be inserted into a remote commander main body 1. As will be explained in detail below, in place of the ROM card 2A a RAM card 2B (not shown in Fig. 1) could also be inserted into commander main body 1. On remote commander main body 1 there are arranged a key switch 3A to control the on/off operation of an internal power supply; a key switch 3B to set the operational mode such as normal mode, learning mode, transfer mode, or the like; and various other key switches, shown generally at 3, that are used to set the necessary minimum commands, such as selection of VTR, TV, CD, setting of audio volume, setting the channel, and the like.

As shown in Fig. 2, a light window 4 for transmitting and receiving infrared command signals is provided on a front end surface 1A of remote commander main body 1. In the case of learning command signals from other remote commanders, the command signals from the other remote commanders are received through the light window 4.

An open section 5 to accept one or more ROM cards 2A, or RAM cards 2B, is formed in the remote commander main body 1. In the embodiment of Fig. 1, provision is made for a plurality of, for instance four, ROM cards 2A, or RAM cards 2B, to be inserted into open section 5 of commander main body 1.

Guide grooves 6 forming a plurality of stages each having a width corresponding to a thickness of a ROM card 2A or RAM card 2B are formed along the inner peripheral surfaces of the open section 5 of remote commander main body 1. Among the plurality of stages of grooves 6, one such stage has a connector portion 7 provided at the position corresponding to the front of the top guide groove 6.

The ROM card 2A or RAM card 2B has a shape corresponding to the open section 5 formed in the remote commander main body 1. An electrical contact portion 31 is formed along the front edge of the ROM card 2A. A similar electrical contact portion is also formed along the front edge of the RAM card.

As shown in Fig. 1, each ROM card 2A, or RAM card, is inserted along the guide groove 6 from the rear of remote commander main body 1. An outer peripheral portion of ROM card 2A fits into guide groove 6, so that the appropriate card is retained in section 5 of remote commander main body 1. In the embodiment shown, four ROM cards 2A, or RAM cards, can be inserted into section 5 in correspondence to the number of stages of the guide grooves 6.

It is understood that only one such card is electrically connected to the circuitry of commander main body 1, with the other cards simply being stored for future use. Thus, among guide grooves 6 formed in section 5, connector portion 7 is formed only at the position corresponding to the top one of guide grooves 6. On the other hand, the electrical contact portions 31 are formed along the front edge of all ROM cards 2A, or RAM cards.

Therefore, among a plurality of ROM cards 2A, or RAM cards, enclosed in open section 5 of remote commander main body 1, the electrical contact portion 31 of the ROM card 2A that is enclosed in the top stage is coupled with connector portion 7 of remote commander main body 1.

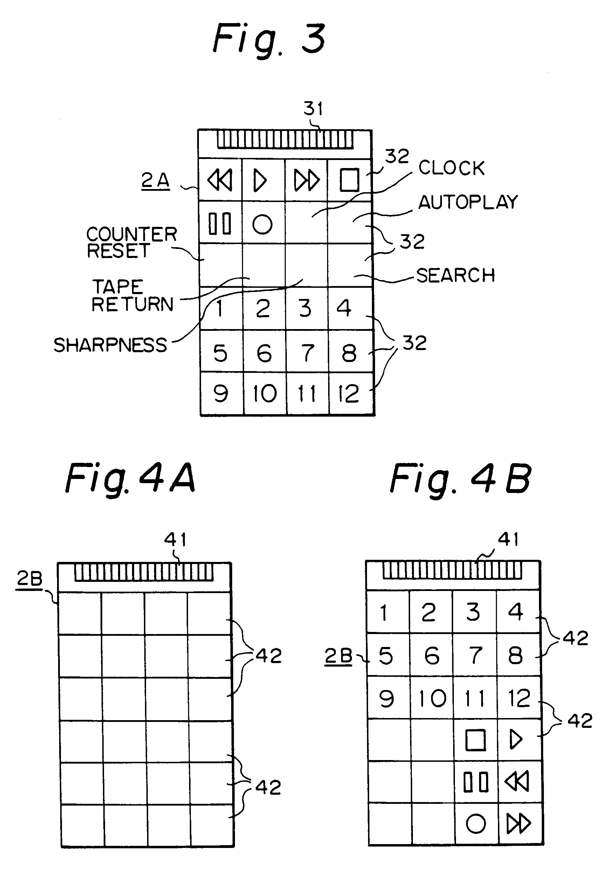

A ROM card 2A is prepared for every electronic apparatus and, as shown in Fig. 3, various key switches, shown typically at 32, are arranged on the upper surface of each card. Characters, figures, and the like corresponding to commands are already displayed on the key switches 32. The command data of the commands corresponding to the displays of key switches 32 are stored in a ROM included in ROM card 2A.

As shown in Figs. 4A and 4B, key switches, shown typically at 42, are also provided on a RAM card 2B. In the initial state, as shown in Fig. 4A, nothing is displayed on the key switches 42. As shown in Fig. 4B, the user can freely write characters, symbols, and the like onto the key switches 42 using a pencil or pen. In the case of the RAM card 2B, the key arrangement can be determined in accordance with the wishes of the user. The command data corresponding to the key arrangement of the key switches 42 is stored in a RAM in the RAM card 2B. Note the arrangement of electrical contacts 41 along the front end of RAM card 2B for making contact with connector 7 in commander main body 1.

In Fig. 1, ROM cards 2A, or RAM cards 2B, are inserted into open section 5 of remote commander main body 1, so that by pressing key switches 32 of ROM card 2A, or switches 42 of RAM card 2B, inserted at the top stage of open section 5, the infrared command signal corresponding to the depressed key switch 32 or 42 is output through light window 4, and the electronic apparatus operated by the infrared command signal.

### (b). Circuit construction of a remote commander main body:

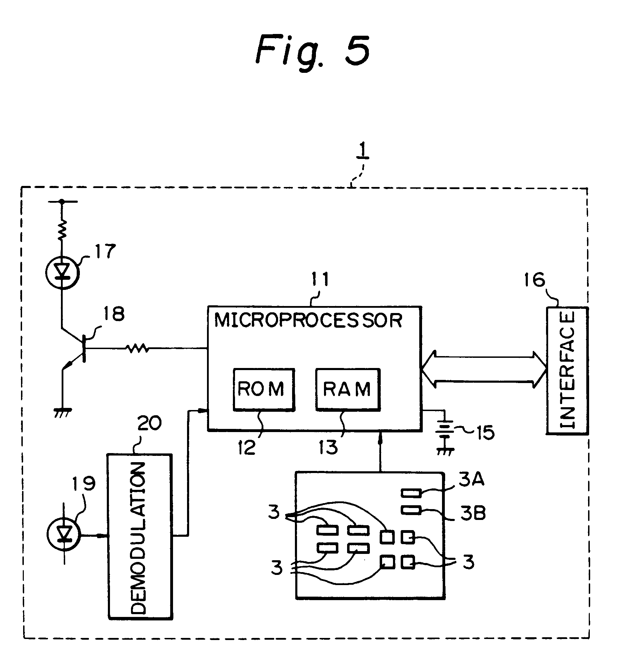

As shown in Fig. 5 the remote commander includes a microprocessor 11, which is a one-chip microprocessor in which a ROM 12 and a RAM 13 are arranged in the same chip. Microprocessor 11 is driven by a power supply 15, and key switches 3, 3A, and 3B are electrically connected to microprocessor 11.

An interface 16 is provided in the remote commander main body 1, and the connector portion 7 (Fig. 1) is led out at interface 16. When a ROM card 2A or RAM card is inserted in the top stage of section 5 of remote commander main body 1, the connector portion 7 of the remote commander main body 1 is coupled with the connector portion 31 of ROM card 2A, or 41 of RAM card 2B. Data can be input/output between the ROM card 2A or RAM card 2B and the microprocessor 11 of the remote commander main body 1 through interface 16.

A light emitting device 17 receives an output of microprocessor 11 through a drive transistor 13, so that an infrared command signal is output from the light emitting device 17. On the other hand, a photo sensitive device 19 receives command signals from the other remote commanders. The command signal detected by photo sensitive device 19 is supplied to a demodulating circuit 20 and the command data is demodulated and supplied to microprocessor 11. The light emitting device 17 and photo sensitive device 19 are arranged in the light window 4 (Fig. 2) on the front surface 1A of remote commander main body 1.

### (c). Circuit construction of ROM card and RAM card:

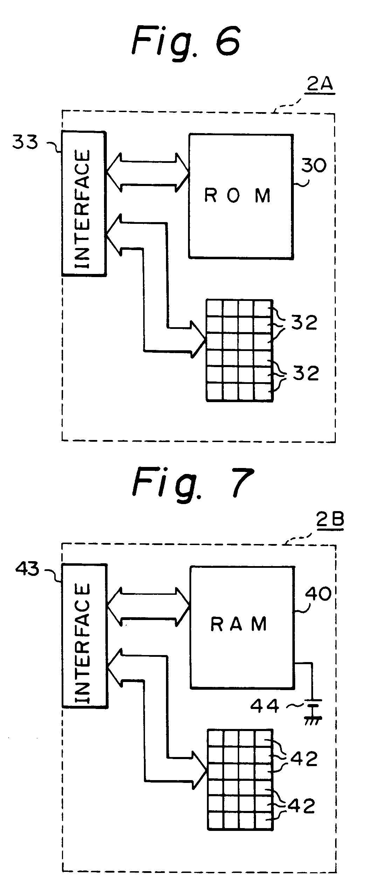

The ROM card 2A as shown in Fig. 6 includes a ROM 30, and key switches 32 are arranged on the upper surface of ROM card 2A. The command data corresponding to the commands of the various key switches 32 arranged on ROM card 2A is already stored in ROM 30 at the time of manufacture of the electronic unit to which the ROM card corresponds. An interface 33 is provided for the ROM card 2A, and the connector portion 31 (Fig. 1) is led out at interface 33. When ROM card 2A is inserted in the top stage of open section 5 of remote commander main body 1, the command data stored in the ROM 30 can be transferred to microprocessor 11 on the remote commander main body 1 side through interface 33.

The RAM card 2B as shown in Fig. 7 includes a RAM 40 that has a backup power supply 44, and the key switches 42 are arranged on RAM card 2B. The command data can be stored in RAM 40 by using the key switches 42 located on the RAM card 2B, and the command data can be rewritten as necessary. An interface 43 is provided on RAM card 2B, and the connector portion 41 (Fig. 1) is led out of interface 43. When RAM card 2B is inserted in the top stage of open section 5 of remote commander main body 1, the command data stored in the RAM 40 can be transferred to microprocessor 11 of the remote commander main body 1 side through interface 43.

### (d). Method of using the operable embodiment.

In using the embodiment of the present invention described above, a ROM card 2A is first prepared for each individual unit of electronic apparatus to be controlled by the commander. The command data corresponding to the key arrangement has already been stored in the ROM card 2A and, therefore, the key arrangement of the ROM card 2A has been predetermined by the manufacturer and cannot be changed.

Only the necessary number of RAM cards 2B need be prepared by the user, and in the initial state, no command data at all is stored in the RAM card 2B. The command data is only stored in the RAM card 2B in accordance with the specific requirements of the user.

In this embodiment, by using the ROM cards 2A each respective electronic apparatus can be easily operated in accordance with the key arrangement that was preset by the manufacturer, in a manner similar to the use of conventional remote commanders. On the other hand, by transferring the command data stored in the ROM card 2A into the RAM card 2B, the key arrangement can be changed in accordance with the wishes of the user. Furthermore, command signals of other remote commanders can be learned by using the RAM card 2B.

For example, in the case of operating each electronic apparatus in accordance with the key arrangement that was preset by the manufacturer in a manner similar to the conventional remote commander, the ROM card 2A prepared for each different species of electronic apparatus is inserted in the top stage of open section 5 of remote commander main body 1.

As shown in Fig. 3, key switches 32 are arranged on the upper surface of ROM card 2A and characters and symbols indicative of the various operating modes are already printed on the key switches 32. The key arrangement of the ROM card 2A is set to the arrangement which can be most easily used by the ordinary user of that specific electronic apparatus. The command signals corresponding to key switches 32 have already been stored in ROM 30 (Fig. 6) of ROM card 2A.

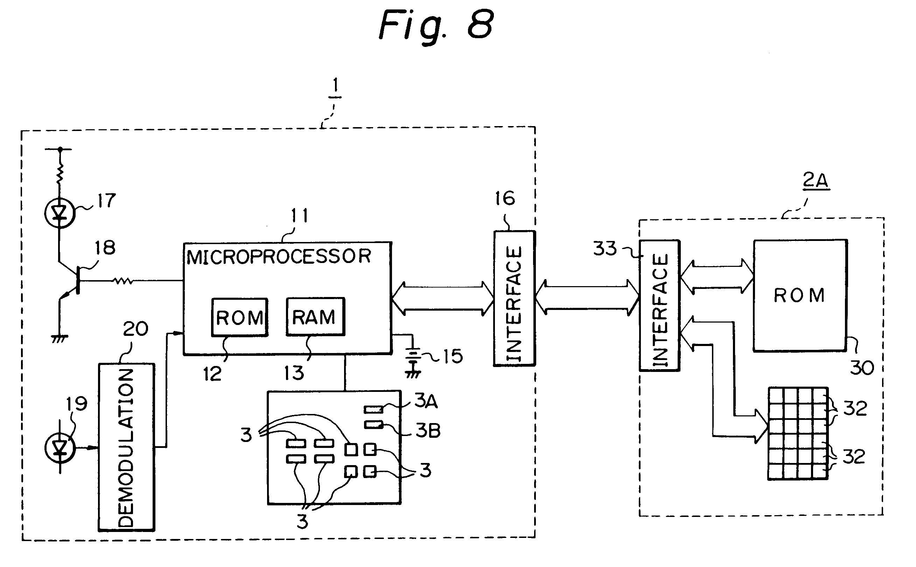

When the ROM card 2A is inserted in the top stage of open section 5 of remote commander main body 1, connector portion 31 at the front edge portion of ROM card 2A is coupled with the connector portion 7 of remote commander main body 1. Therefore, as shown in Fig. 8, data can be transmitted and received between ROM 30 in the ROM card 2A and microprocessor 11 of remote commander main body 1 through interface 33 of the ROM card 2A and interface 16 of the remote commander main body 1.

When one of key switches 32 arranged on ROM card 2A is pressed, the corresponding command data is read out of ROM 30 and sent to microprocessor 11. A command signal is formed by microprocessor 11 on the basis of that command data, and an output of microprocessor 11 is supplied to light emitting device 17 through driver 18, so that an infrared command signal based on the command signal is output from light emitting device 17 through light window 4.

As mentioned above, the command data has already been stored in the ROM card 2A so as to provide the key arrangement which can be most easily used by the ordinary person. Therefore, by using ROM card 2A, the electronic apparatus can be operated by operations similar to those of the conventional remote commander without needing any complicated instructions.

Even though the key arrangement of the ROM card 2A has been predetermined, if the user feels it difficult to operate the keys in such arrangement, the key arrangement may be changed and the command data of the ROM card 2A transferred to the RAM card 2B.

The following operations are executed in the case of transferring the command data stored in the ROM card 2A to the RAM card 2B.

In the case where the command data stored in ROM card 2A is transferred to the RAM card 2B, the ROM card 2A containing the information to be transferred is first inserted in the top stage of open section 5 of remote commander main body 1, so that the connector portion 31 along the front edge of ROM card 2A is coupled with connector portion 7 of remote commander main body 1. Therefore, as seen from Fig. 8, data can be transmitted and received between ROM 30 in ROM card 2A and microprocessor 11 of the remote commander main body 1 through interface 33 of ROM card 2A and interface 16. When ROM card 2A is inserted in the top stage of open section 5, the transfer mode is set by operating key switch 3B on commander main body 1.

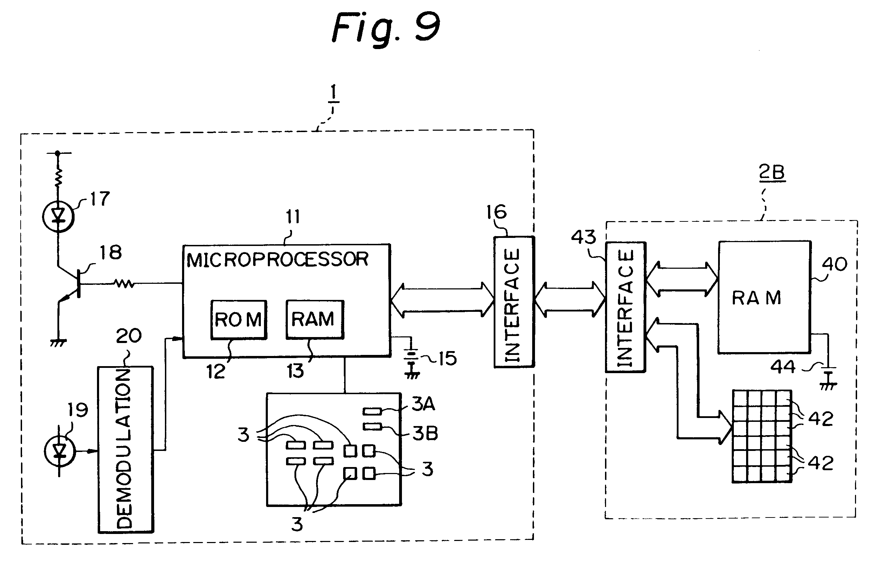

By pressing various key switches 32 arranged on ROM card 2A, the command data corresponding to key switches 32 is read out. In the transfer mode, when the command data stored in ROM card 2A is read out, the command data is temporarily stored in RAM 13 of the microprocessor 11 and ROM card 2A is removed from the top stage of open section 5. In place of this card, RAM card 2B to which the command data will be transferred is inserted into the top stage of open section 5, and connector 41 along the front edge of RAM card 2B is coupled with connector portion 7 of remote commander main body 1. Therefore, as shown in Fig. 9, data can be transmitted and received between RAM 40 in RAM card 2B and microprocessor 11 of remote commander main body 1 through interface 43 of the RAM card 2B and the interface 16.

Among the key switches 42 arranged on RAM card 2B, key switch 42 at the position suitable to execute the operation of such a command is pressed. By doing this the command data of ROM card 2A, which has temporarily been stored in RAM 13 of microprocessor 11 of remote commander main body 1, is stored in RAM 40 in RAM card 2B in correspondence to the particular key switch 42 pressed at that time. Thus, the command data stored originally in the ROM card 2A is transferred to RAM card 2B. After the command data is stored in RAM card 2B, the characters and symbols corresponding to the various commands can be written with pencil or pen onto key switches 42 on the upper surface of RAM card 2B.

By an operation similar to that described above, command data can be also transferred between one RAM card 2B and another RAM card 2B.

By storing the command data of the ROM card 2A into the RAM card 2B, a remote commander having any original key arrangement according to the user's requirements can be realized.

There is also the case where an audio-visual system is constructed using electronic apparatus from various manufacturers, in which the remote commanders of the electronic apparatus of the other companies do not have such ROM cards 2A. In such a case, therefore, the command data of the other remote commanders are learned and the command data of the other remote commanders are stored into the RAM cards 2B. The following operations are executed in the case of learning the command signals of another remote commander.

In the case of learning the command signals of another remote commander, a RAM card 2B is inserted into the top stage of open section 5 of commander main body 1, and the learning mode is set by operating key switch 3B. The arrangements where the RAM card 2B is inserted into the top stage of the open section 5 of commander main body 1 is shown in Fig. 9.

When RAM card 2B is in the top stage of open section 5 of commander main body 1 and the learning mode is set by key switch 3B, the other remote commander is arranged such that its light emitting section is close to the light window 4 at the front side 1A of remote commander main body 1.

The operation key switch of the other remote commander is pressed and the appropriate key switch 42 of RAM card 2B is also pressed. When the operation key switch of the other remote commander is pressed, an infrared command signal is output from the remote commander and is detected by the photosensitive device 19 and is demodulated by demodulating circuit 20. The demodulated command data is supplied to microprocessor 11, and the command data is sent to RAM 40 of RAM card 2B through interfaces 16 and 43 and stored into RAM 40 of RAM card 2B.

When the learning mode is set as mentioned above, the command data of the remote commander of another manufacturer can be stored in RAM 40 of RAM card 2B. If the command data of the remote commander of another company is stored in RAM 40 of RAM card 2B, even in the case of constructing an audio-visual system by combining various items of electronic apparatus of other companies, such plurality of electronic apparatus can be operated by one remote commander. Since various kinds of electronic apparatus can be operated by merely exchanging the RAM card 2B, there is no need to increase the number of key switches on the remote commander main body 1. Thus, the operating efficiency is good.

According to the present invention, the command data is stored in the card-shaped ROM card 2A or RAM card 2B that is detachably retained in the remote commander main body 1.

The command data of the other ROM card 2A or RAM card 2B can be transferred to the RAM card 2B and by transferring the command data of the other ROM card 2A or RAM card 2B as mentioned above, a remote commander having a key arrangement wholly original to the user can be realized.

On the other hand, the command data of another remote commander can be learned and the command data can be stored into the RAM card 2B. In this manner, since the command signals of the remote commander can be learned, even in the case of constructing an audio-visual system by collecting electronic apparatus of other companies, the assembled apparatus can be operated by one remote commander.

Since the command data of various kinds of electronic apparatuses are stored on every RAM card 2B, the number of keys on the remote commander 1 is not increased. Therefore, the operating efficiency is good.

On the other hand, because a plurality of guide grooves 6 are formed in the opening portion 5 of the remote commander main body 1, the ROM cards 2A or RAM cards 2B not presently in use can be stored in the opening portion 5.

Having described a specific preferred embodiment of the present invention with reference to the accompanying drawings, it is to be understood that the invention is not limited to that precise embodiment, and that various changes and modifications may be effected therein by one skilled in the art without departing from the scope or spirit of the invention as defined in the appended claims.

## Claims

1. A commander apparatus having a main body (1):
record media (2A,2B) including actuatable key switches (3) and in which control data corresponding to the key switches is stored, said record media being detachably mounted in the commander main body;
receiving means (19) arranged in said main body for receiving command signals which are supplied from outside the commander;
control means including a demodulator (20) for storing control data obtained by demodulating said command signals supplied from outside the commander in correspondence to the key switches of said record media; and
coupling means (5,6,31) for electrically coupling said recording media with said remote commander main body.

2. A commander apparatus as claimed in Claim 1, wherein the main body enclosing means for enclosing a plurality of said recording media is formed in said remote commander main body and a record medium for coupling with said remote commander is selected from among the plurality of record media enclosed in said enclosing means.

3. A commander apparatus as claimed in Claim 1, wherein said key switch arrangement of said record medium is preset and in which the control data is stored in said record media in correspondence to the preset key switch arrangement.

4. A commander apparatus as claimed in Claim 1, wherein said key switch arrangement is not fixed and can be freely set and in which the control data is stored in correspondence to a selected key switch arrangement.

5. A commander apparatus as claimed in Claim 1, including means for selecting a learning mode, in which among the command data of other remote commanders, required command data can be stored in said record media in accordance with a selected key switch arrangement.

6. A commander apparatus as claimed in Claim 1 including means for selecting a transfer mode, in which among the command data in one record medium, the necessary command data can be stored in other record media in accordance with a selected key switch arrangement.

7. A commander apparatus in which recording media in which control data corresponding to key switches is stored are detachably mounted in a remote commander main body, comprising:
receiving means for receiving command signals supplied from outside the remote commander main body;
control means includes a demodulator for storing control data which is obtained by demodulating said command signals supplied from the outside in correspondence to selected ones of the key switches of said recording media; and
coupling means for electrically coupling said recording media with said remote commander main body.

8. A commander apparatus as claimed in Claim 7, including enclosing means for enclosing a plurality of said recording media in said remote commander main body and a recording medium for electrically coupling with said remote commander is selected from among a plurality of recording media enclosed in said enclosing means.

9. A commander apparatus as claimed in Claim 7, wherein said recording media comprises a ROM card on which the key switch arrangement is fixedly predetermined and in which the command data is stored in correspondence to the fixedly predetermined key switch arrangement.

10. A commander apparatus as claimed in Claim 7, wherein said recording media comprises a RAM card on which a key switch arrangement can be freely selected and in which the command data can be stored in correspondence to the freely selected key switch arrangement.

11. A commander apparatus as claimed in Claim 7, including means for selecting a learning mode, in which mode among the command data of other remote commanders, the required command data can be stored in said recording media in accordance with a selected key switch arrangement.

12. A commander apparatus as claimed in Claim 7, including means for selecting a transfer mode, in which mode among the command data in one recording medium, required command data can be stored in other recording media in accordance with a selected key switch arrangement.

## Patentansprüche

1. Steuergerät mit:
- einem Hauptkörper (1);
- Aufzeichnungsmedien (2A, 2B), zu denen betätigbare Tastenschalter (3) gehören und in denen Steuerdaten, die den Tastenschaltern entsprechen, abgespeichert sind, und die wegnehmbar im Hauptkörper der Steuerung untergebracht sind;
- einer Empfangseinrichtung (19), die im Hauptkörper angeordnet ist, um Befehlssignale zu empfangen, die von außerhalb der Steuerung zugeführt werden;
- einer Steuereinrichtung mit einem Demodulator (20) zum Abspeichern von Steuerdaten, die durch Demodulieren der von außerhalb der Steuerung zugeführten Befehlssignale empfangen werden, in Entsprechnung zu den Tastenschaltern der Aufzeichnungsmedien; und
- einer Kopplungseinrichtung (5, 6, 31) zum elektrischen Verbinden der Aufzeichnungsmedien mit dem Hauptkörper der Fernsteuerung.

2. Steuergerät nach Anspruch 1, in dem die Hauptkörper-Unterbringungseinrichtung zum Unterbringen mehrerer der genannten Aufzeichnungsmedien im Hauptkörper der Fernsteuerung ausgebildet ist und ein Aufzeichnungsmedium zum Verbinden der Fernsteuerung aus den mehreren in der Unterbringungseinrichtung untergebrachten Aufzeichnungsmedien ausgewählt ist.

3. Steuergerät nach Anspruch 1, bei dem die Tastenschalteranordnung des Aufzeichnungsmediums vorgegeben ist und bei dem die Steuerdaten entsprechend der vorgegebenen Tastenschalteranordnung im Aufzeichnungsmedium abgespeichert sind.

4. Steuergerät nach Anspruch 1, bei dem die Tastenschalteranordnung nicht festliegt und frei eingestellt werden kann und bei dem die Steuerdaten abhängig von einer gewählten Tastenschalteranordnung abgespeichert sind.

5. Steuergerät nach Anspruch 1, mit einer Einrichtung zum Auswählen eines Lernmodus, in dem von den Befehlsdaten anderer Fernsteuerungen erforderliche Befehlsdaten im Aufzeichnungsmedium gemäß einer ausgewählten Tastenschalteranordnung eingespeichert werden können.

6. Steuergerät nach Anspruch 1, mit einer Einrichtung zum Auswählen eines Übertragungsmodus, in dem unter den Steuerdaten in einem Aufzeichnungsmedium die erforderlichen Steuerdaten in anderen Aufzeichnungsmedien abhängig von einer gewählten Tastenschalteranordnung eingespeichert werden können.

7. Steuergerät, bei dem Aufzeichnungsmedien, in denen Tastenschaltern entsprechende Steuerdaten abgespeichert sind, wegnehmbar in einem Hauptkörper einer Fernsteuerung untergebracht sind, mit:
- einer Empfangseinrichtung zum Empfangen von Befehlssignalen, die von außerhalb des Hauptkörpers der Fernsteuerung zugeführt werden;
- einer Steuereinrichtung mit einem Demodulator zum Abspeichern von Steuerdaten, die durch Demodulieren der von der Außenseite zugeführten Befehlssignale in Entsprechung zu ausgewählten Tastenschaltern der Tastenschalter der Aufzeichnungsmedien erhalten werden; und
- einer Kopplungseinrichtung zum elektrischen Verbinden der Aufzeichnungsmedien mit dem Hauptkörper der Fernsteuerung.

8. Steuergerät nach Anspruch 7, mit einer Unterbringungseinrichtung zum Unterbringen mehrerer der genannten Aufzeichnungsmedien im Hauptkörper der Fernsteuerung, und bei dem ein Aufzeichnungsmedium zum elektrischen Koppeln mit der Fernsteuerung aus den mehreren in der Unterbringungseinrichtung untergebrachten Aufzeichnungsmedien ausgewählt ist.

9. Steuergerät nach Anspruch 7, bei dem die Steuermedien eine ROM-Karte aufweisen, bei der die Tastenschalteranordnung fest vorgegeben ist und in der die Steuerdaten in Entsprechung zur fest vorgegebenen Tastenschalteranordnung abgespeichert sind.

10. Steuergerät nach Anspruch 7, bei dem die Aufzeichnungsmedien eine RAM-Karte aufweisen, bei der die Tastenschalteranordnung frei gewählt werden kann und in die die Steuerdaten in Entsprechung zur frei gewählten Tastenschalteranordnung eingespeichert werden können.

11. Steuergerät nach Anspruch 7, mit einer Einrichtung zum Auswählen eines Lernmodus, in dem von den Befehlsdaten anderer Fernsteuerungen erforderliche Befehlsdaten im Aufzeichnungsmedium gemäß einer ausgewählten Tastenschalteranordnung eingespeichert werden können.

12. Steuergerät nach Anspruch 7, mit einer Einrichtung zum Auswählen eines Übertragungsmodus, in dem unter den Steuerdaten in einem Aufzeichnungsmedium die erforderlichen Steuerdaten in anderen Aufzeichnungsmedien abhängig von einer gewählten Tastenschalteranordnung eingespeichert werden können.

## Revendications

1. Appareil de dispositif de commande comportant un corps principal (1), des supports d'enregistrement (2A, 2B) incluant des commutateurs à touche actionnables (3) et dans lequel des données de commande correspondant aux commutateurs à touche sont stockées, lesdits supports d'enregistrement étant montés de façon amovible dans le corps principal de dispositif de commande ;
un moyen de réception (19) agencé dans ledit corps principal pour recevoir des signaux de commande qui sont appliqués depuis l'extérieur du dispositif de commande ;
un moyen de commande incluant un démodulateur (20) pour stocker des données de commande obtenues en démodulant lesdits signaux de commande appliqués depuis l'extérieur du dispositif de commande en correspondance avec les commutateurs à touche desdits supports d'enregistrement ; et
un moyen de couplage (5, 6, 31) pour coupler électriquement lesdits supports d'enregistrement audit corps principal de dispositif de commande à distance.

2. Appareil de dispositif de commande selon la revendication 1, dans lequel un moyen d'enceinte de corps principal permettant d'enfermer une pluralité de dits supports d'enregistrement est formé dans ledit corps principal de dispositif de commande à distance et un support d'enregistrement pour réaliser un couplage avec ledit dispositif de commande à distance est choisi parmi la pluralité de supports d'enregistrement enfermés dans ledit moyen d'enceinte.

3. Appareil de dispositif de commande selon la revendication 1, dans lequel ledit agencement de commutateurs à touche dudit support d'enregistrement est pré-établi et dans lequel les données de commande sont stockées dans lesdits supports d'enregistrement en correspondance avec l'agencement de commutateurs à touche pré-établi.

4. Appareil de dispositif de commande selon la revendication 1, dans lequel ledit agencement de commutateurs à touche n'est pas fixé et peut être établi librement et dans lequel des données de commande sont stockées en correspondance avec un agencement de commutateurs à touche sélectionné.

5. Appareil de dispositif de commande selon la revendication 1, incluant un moyen pour sélectionner un mode apprentissage, dans lequel, parmi les données de commande d'autres dispositifs de commande à distance, des données de commande requises peuvent être stockées dans lesdits supports d'enregistrement en relation avec un agencement de commutateurs à touche sélectionné.

6. Appareil de dispositif de commande selon la revendication 1, incluant un moyen pour sélectionner un mode transfert, dans lequel, parmi les données de commande contenues dans un support d'enregistrement, les données de commande nécessaires peuvent être stockées dans d'autres supports d'enregistrement en relation avec un agencement de commutateurs à touche sélectionné.

7. Appareil de dispositif de commande dans lequel des supports d'enregistrement dans lesquels des données de commande correspondant à des commutateurs à touche sont stockées sont montés de façon amovible dans un corps principal de dispositif de commande à distance, comprenant :
un moyen de réception pour recevoir des signaux de commande appliqués depuis l'extérieur du corps principal de dispositif de commande à distance ;
un moyen de commande incluant un démodulateur pour stocker des données de commande qui sont obtenues en démodulant lesdits signaux de commande appliqués depuis l'extérieur en correspondance avec certains sélectionnés des commutateurs à touche desdits supports d'enregistrement ; et
un moyen de couplage pour coupler électriquement lesdits supports d'enregistrement audit corps principal de dispositif de commande à distance.

8. Appareil de dispositif de commande selon la revendication 7, incluant un moyen d'enceinte permettant d'enfermer une pluralité desdits supports d'enregistrement dans ledit corps principal de dispositif de commande à distance et un support d'enregistrement en vue d'un couplage électrique avec ledit dispositif de commande à distance est choisi parmi une pluralité de supports d'enregistrement enfermés dans ledit moyen d'enceinte.

9. Appareil de dispositif de commande selon la revendication 7, dans lequel lesdits supports d'enregistrement comprennent une carte à mémoire morte (ROM) sur laquelle l'agencement de commutateurs à touche est prédéterminé de façon fixe et dans lequel les données de commande sont stockées en correspondance avec l'agencement de commutateurs à touche prédéterminé de façon fixe.

10. Appareil de dispositif de commande selon la revendication 7, dans lequel lesdits supports d'enregistrement comprennent une carte à mémoire vive (RAM) sur laquelle un agencement de commutateurs à touche peut être librement sélectionné et dans laquelle les données de commande peuvent être stockées en correspondance avec l'agencement de commutateurs à touche sélectionné librement.

11. Appareil de dispositif de commande selon la revendication 7, incluant un moyen pour sélectionner un mode apprentissage, mode dans lequel parmi les données de commande d'autres dispositifs de commande à distance, les données de commande requises peuvent être stockées dans lesdits supports d'enregistrement en relation avec un agencement de commutateurs à touche sélectionné.

12. Appareil de dispositif de commande selon la revendication 7, incluant un moyen pour sélectionner un mode transfert, mode dans lequel parmi les données de commande contenues dans un support d'enregistrement, des données de commande requises peuvent être stockées dans d'autres supports d'enregistrement en relation avec un agencement de commutateurs à touche sélectionné.
